# EUROPEAN PATENT APPLICATION

(11) **EP 1 324 398 A2**
(43) Date of publication of application: **02.07.2003**
(21) Application number: 02258551.7
(22) Date of filing: 11.12.2002
(51) Int. Cl.: H01L 31/18, H01L 33/00

(54) **Metal oxide semiconductor thin film and method of producing the same**

(30) Priority: 12.12.2001 JP 2001378118
(71) Applicant: National Institute of Advanced Industrial Science and Technology, Tokyo (JP)
(72) Inventor: Iwata, Kakuya, Tsukuba-shi, Ibaraki 305-8568 (JP)
(74) Representative: Smith, Norman Ian

(57) **Abstract**

An organometal having as molecular structural elements both a semiconductor anion atom and cation atom is applied to a substrate and reacted under heating to obtain p-type and n-type semiconductor thin films whose p-n junctions enable fabrication of a semiconductor device, light-emitting element or solar cell.

## Description

The present invention relates to a metal oxide semiconductor thin film fabricated by chemically reacting an organometal having a semiconductor anion atom and cation atom in its structural molecule and to a method of producing the thin film

In the past, the method of firing an oxygen atom-containing organometal immersed in an organic solvent solution (sol-gel process) was used to fabricate glass, ceramic and dielectric coating films, fiber and bulk semiconductor, but not to fabricate semiconductor thin film.

This was because the properties of oxide semiconductors had not been thoroughly researched and it was not known that they exhibit p-type and n-type semiconductor characteristics even when polycrystalline.

Only in recent years was it finally ascertained that thin films fabricated using organometallic compound solvent have electric conductivity and clarified that the conductivity mode exhibits n-type semiconductor property. Application has, however, been limited to transparent conductive film (see, for example, JP-A 2000-36244).

Although semiconductor devices, particularly solar cells, have conventionally been fabricated using silicon crystal, amorphous silicon or the like, fabrication cost has been high with any of these owing to the difficulty of large area fabrication and the complexity of the fabrication process.

An object of the present invention is therefore to provide a semiconductor thin film that enables inexpensive and rapid fabrication of solar cells and other semiconductor devices having multiple p-n junction layers and the like. Another object of the present invention is to provide a method of producing the semiconductor thin film.

Another object of the present invention is to provide a method of producing large-area laminated semiconductor thin films in high volume.

To attain these objects, the present invention provides a method of producing a metal oxide semiconductor thin film that utilizes a process of fabricating a semiconductor thin film by chemically reacting an organic molecule.

Specifically, the method of producing a metal oxide semiconductor thin film according to the present invention fundamentally comprises the steps of adhering a mixed solution of an organometal containing an oxygen atom and a solvent to a substrate and decomposing and oxidizing the organometal by heat treatment at a predetermined temperature.

When an n-type semiconductor is to be fabricated, the organometal can be zinc oxide or zinc oxide compound doped with aluminum, boron, gallium or indium.

When a p-type semiconductor is to be fabricated, the organometal can be sodium cobalt oxide, copper oxide, aluminum copper oxide, gallium copper oxide, strontium copper oxide or nickel copper oxide doped with aluminum, sodium, potassium or lithium.

The method of manufacturing semiconductor thin film of the present invention can comprise the steps of adhering a mixed solution of an organometal containing a p-type impurity and a solvent to a substrate, heat-treating the adhered mixed solution at a predetermined temperature to form a p-type oxide semiconductor thin film, adhering a mixed solution of an organometal containing an n-type impurity and a solvent to the thin film, and heat-treating the adhered mixed solution at a predetermined temperature to form an n-type oxide semiconductor thin film, thereby fabricating a p-n junction.

The organometal containing the p-type impurity can be sodium cobalt oxide, copper oxide, aluminum copper oxide, gallium copper oxide, strontium copper oxide or nickel copper oxide doped with aluminum, sodium, potassium or lithium, and the organometal containing the n-type impurity can be zinc oxide or zinc oxide compound doped with aluminum, boron, gallium or indium.

Production of semiconductor thin film according to the present invention can be production utilizing a sol-gel process.

The substrate can be made of metal, ceramic, glass or heat-resistant plastic.

The metal oxide semiconductor thin film of this invention can be a thin film fabricated by heat-treating a mixed solution of an organometal containing an oxygen atom and an organic solvent adhered to a substrate at a predetermined temperature to decompose and oxidize the organometal.

When the fabricated semiconductor is n-type, the organometal can be zinc oxide or zinc oxide compound doped with aluminum, boron, gallium or indium.

When the fabricated semiconductor is p-type, the organometal can be sodium cobalt oxide, copper oxide, aluminum copper oxide, gallium copper oxide, strontium copper oxide or nickel copper oxide doped with aluminum, sodium, potassium or lithium.

The semiconductor thin film according to the present invention can be a thin film having a p-n junction formed of a p-type oxide semiconductor thin film obtained by heat-processing a mixed solution of an organometal containing a p-type impurity and a solvent adhered to the substrate at a predetermined temperature and an n-type oxide semiconductor thin film formed by adhering a mixed solution of an organometal containing an n-type impurity and a solvent to the thin film and heat-treating the adhered mixed solution at a predetermined temperature.

In the present invention, an organometal molecule having as structural elements both an anion atom and a cation atom of the semiconductor to be fabricated is applied to a substrate by spraying, dipping, spin coating or the like and reacted under heating to obtain p-type and n-type semiconductor thin films whose p-n junction and/or formation in multiple layers enable rapid fabrication of large-area semiconductor devices, light-emitting elements and solar cells inexpensively and in high volume.

The above and other objects, features and advantages will become apparent to those skilled in the art from the description given below with reference to the accompanying drawings, in which:
Figure 1 is an overview for explaining a sol-gel process,
Figure 2 is a band diagram of oxide semiconductors,
Figure 3 is a chart showing a process for fabricating an n-type semiconductor thin film in accordance with the present invention,
Figure 4 is a graph showing change in resistivity of zinc oxide semiconductor thin film with heating temperature of organometal molecule thin film,
Figure 5 is a chart showing a process for fabricating a solar cell according the present invention by use of a dipping method, and
Figure 6 is a chart showing a process for fabricating a solar cell according the present invention by use of vapor deposition and heating.

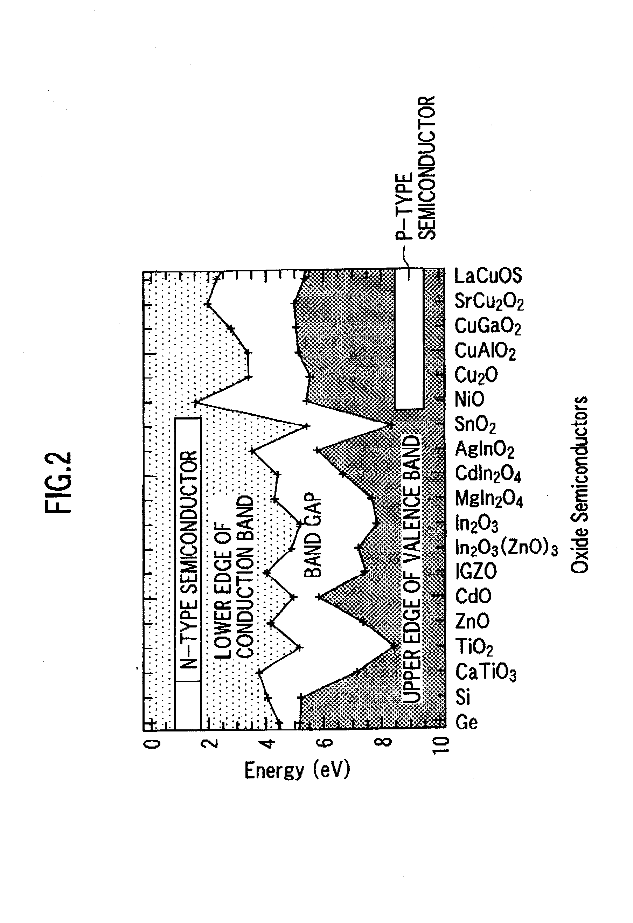

The present invention was prompted by the existence of n-type oxide semiconductor and p-type oxide semiconductor. Figure 2 shows the forbidden bands of major oxide semiconductors and the energy positions of their conduction bands and valence bands relative to the vacuum level. From Figure 2 it can be seen that oxide semiconductors fall into groups, including the zinc oxide, indium oxide and other groups whose energy at the lower edge of the conduction band exhibits deep n-type semiconductor property as viewed from the vacuum level and the cuprous oxide and nickel oxide group whose valence band upper edge exhibits shallow p-type semiconductor property as viewed from the vacuum level. The fact that oxides of different metals can form p-n junctions is known from studies of oxide semiconductors conducted up to now. This leads to an expectation of being able to realize semiconductor devices and solar cells having oxide p-n junctions.

Encouraged by this prospect, the inventors sought to develop oxide semiconductors by fabricating oxide semiconductors and p-n junctions utilizing decomposition/oxidization of organometals.

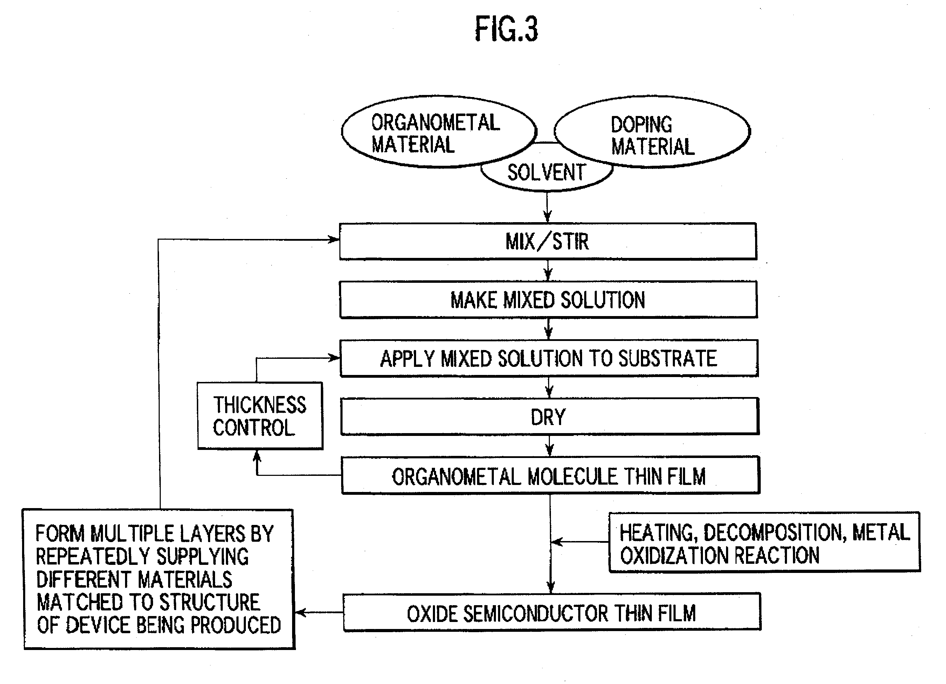

First, the method of producing an n-type semiconductor thin film of the present invention will be explained with reference to the process diagram of Figure 3.

Organometals containing an oxygen atom include zinc acetate, zinc acetylacetonate, zinc formate, zinc hydroxide, zinc chloride, zinc nitrate, and their hydrates.

Doping materials include aluminum nitrate, aluminum acetate, aluminum chloride, aluminum sulfate, aluminum formate, gallium nitrate, gallium acetate, gallium chloride, gallium sulfate, gallium formate, indium nitrate, indium acetate, indium chloride, indium sulfate, indium formate, boron nitrate, boron acetate, boron chloride, boron sulfate, boron formate, and their hydrates.

Solvents include alcohol and water.

The organometal, doping material and ethanol are thoroughly mixed by stirring for 2 - 3 hours at a temperature in the range from around room temperature to 100°C to make an n-type organometal material-mixed solution.

Next, a substrate is immersed in the obtained mixed solution to form a thin film of the mixed solution on the substrate, whereafter the solvent is volatized by drying to produce an organometal molecule thin film on the substrate.

The material of the substrate is limited only in that it must be able to withstand the temperature of the heat treatment explained later and can be any of various materials, such as metal, ceramic, glass or heat-resistant plastic.

The aforesaid method of adhering the mixed solution to the substrate by immersing it in the mixed solution is only one of various methods that can be used. Others include application by dipping or spin coating,

The number of repetitions of the coating, dipping or spin coating is controlled to control the thickness of the thin film formed on the substrate.

The organometal molecule thin film formed on the substrate is transformed from the organometal molecule thin film to an n-type metal oxide semiconductor by subsequent heating, decomposition and other chemical reactions. The heating temperatures for producing these chemical reactions are, for example, 400 - 600°C in the case of zinc oxide, 200 - 400°C in the case of indium oxide and 200 - 600°C in the case of tin oxide.

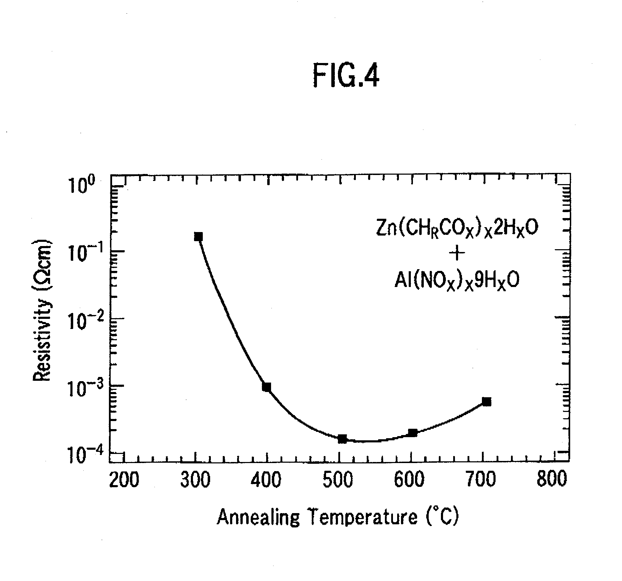

Figure 4 shows how the resistivity of a thin film formed of a mixture of aluminum nitrate 9-hydrate and ethanol depended on heat treatment (annealing) temperature. It can be seen that setting the heat treatment temperature at around 500°C lowered the resistivity and enabled transformation of organometal molecule thin film to semiconductor thin film.

The method of producing a p-type semiconductor thin film of the present invention will now be explained. As the processes for manufacturing the semiconductor thin film are substantially the same as those for the n-type semiconductor thin film shown in Figure 3, the explanation will again be made with reference to Figure 3.

Organometals containing oxygen atom include copper acetate, copper formate, copper sulfate, copper chloride, copper nitrate, nickel acetate, nickel formate, nickel sulfate, nickel chloride nickel nitrate, sodium cobalt nitrate, sodium cobalt acetate, sodium cobalt formate, sodium cobalt sulfate, sodium cobalt chloride, sodium nickel nitrate, and their hydrates.

Doping materials include aluminum nitrate, aluminum acetate, aluminum chloride, aluminum sulfate, aluminum formate, sodium nitrate, sodium acetate, sodium chloride, sodium sulfate, sodium formate, potassium nitrate, potassium acetate, potassium chloride, potassium sulfate, potassium formate, lithium nitrate, lithium acetate, lithium chloride, lithium sulfate, lithium formate, and their hydrates.

The organometal and doping material are dissolved in ethanol or other solvent and thoroughly mixed by stirring to make a p-type organometal material mixed solution.

Next, a thin film of the mixed solution is formed on a substrate by coating, dipping, spin coating or the like, whereafter the solvent is volatized by drying to produce an organometal molecule thin film on the substrate.

The same types of substrate can be used as in the case of producing n-type semiconductor. The number of repetitions of the coating, dipping or spin coating is controlled to control the thickness of the mixed solution applied to the substrate.

The organometal molecule thin film formed on the substrate is transformed from the organometal molecule thin film to a p-type metal oxide semiconductor by subsequent heating, decomposition and other chemical reactions. The heating temperatures for producing these chemical reactions are, for example, 300 - 1,700°C in the case of copper oxide, 400 - 1,900°C in the case of nickel oxide and 300 - 2,000°C in the case of sodium cobalt oxide.

When an n- or p-type metal oxide semiconductor thin film is formed on one surface of a substrate by the process of Figure 3 in the foregoing manner and a thin film of the other type (p- or n-type) metal oxide semiconductor is then formed on the first semiconductor thin film by the same process, a p-n junction is obtained.

Moreover, a multilayer semiconductor device can be produced by repeating the steps of supplying a predetermined material selected in accordance with the desired semiconductor device structure to form an organometal molecule thin film, heating and decomposing the thin film to obtain a semiconductor thin film, supplying onto the thin film a material for a different thin film, and heating and decomposing the different thin film to obtain a subsequent semiconductor thin film.

The aforesaid n- and p-type metal oxide semiconductor thin films can be readily produced using a sol-gel process.

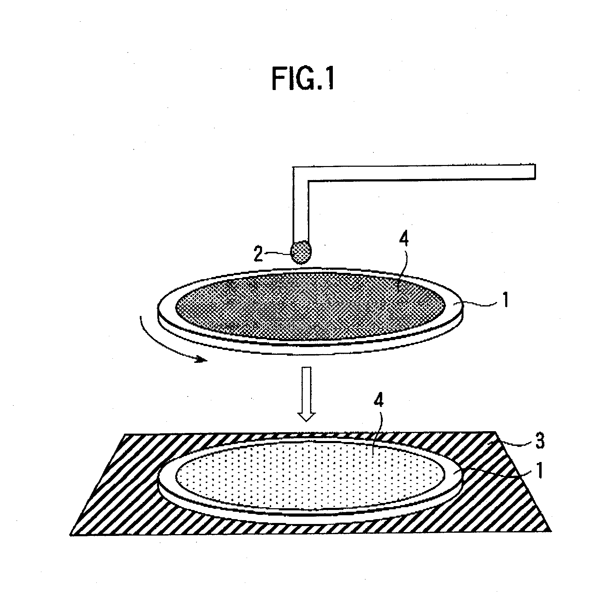

Figure 1 schematically illustrates a sol-gel process utilizing spin coating. A mixed solution of n- or p-type organometal material 2 is dripped onto a substrate 1 being rotated at speed of about 100 - 500 rpm. The rotating speed after dripping (1,000 - 4,000 rpm) and the viscosity and temperature of the mixed solution are regulated to control the thickness of the so-formed thin film.

When the mixed solution film 4 on the substrate 1 reaches a predetermined thickness, a heater 3 is used to heat it to around 250°C to evaporate its solvent component and then to the temperature cited earlier for causing chemical reaction of the organometal material, thereby heat-treating the film 4 to produce a metal oxide semiconductor thin film.

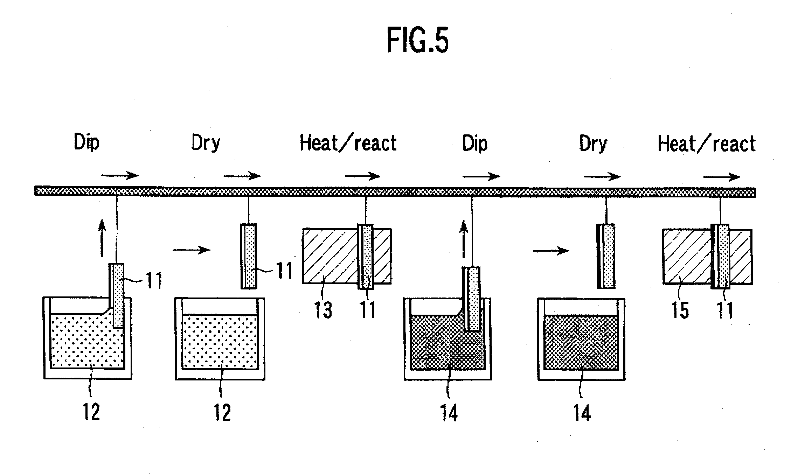

A method of producing a solar cell that utilizes the dip method to form a p·n junction on a substrate will now be explained with reference to Figure 5.

A substrate 11 made of glass, ceramic, heat-resistant plastic, metal or the like and formed with metal electrodes is immersed in a p-type organometal material mixed solution 12.

The mixed solution can be one of those mentioned in the earlier explanation regarding production of p-type semiconductor.

After the substrate 11 has been withdrawn from the mixed solution 12 and dried, it is passed through a heater 13 to subject the organometal molecule thin film on the substrate to chemical reaction that transforms it to a metal oxide semiconductor thin film. The heating temperature by the heater 13 for causing the chemical reaction is, for example, 300 - 1,700°C when the p-type organometal material is copper oxide, 400 - 1,900°C when it is nickel oxide and 300 - 2,000°C when it is sodium cobalt oxide.

When a p-type semiconductor thin film 11p has been formed on the substrate 11 in the foregoing manner, the substrate 11 bearing the thin film is immersed in an n·type organometal material mixed solution 14.

The mixed solution can be one of those mentioned in the earlier explanation regarding production of n-type semiconductor.

After the substrate 11 has been withdrawn from the mixed solution 14 and dried, it is heated by a heater 15 to produce a reaction that forms an n-type metal oxide semiconductor thin film 1 in on the p-type metal oxide semiconductor thin film lip. thereby forming a p-n junction structure that constitutes a solar cell.

The heating temperature by the heater 15 is, for example, 400 - 600°C when the n-type organometal material is zinc oxide, 200 - 400°C when it is indium oxide and 200 - 600°C when it is tin oxide.

Use of this dip method is an excellent choice for production of solar cells because it enables large-area p-n junction semiconductor to be produced easily, rapidly and inexpensively. The coating method, which resembles the dip method in the point of being substantially free of coating unevenness, can also be applied using large-area compatible equipment to produce large-area devices easily, rapidly and inexpensively.

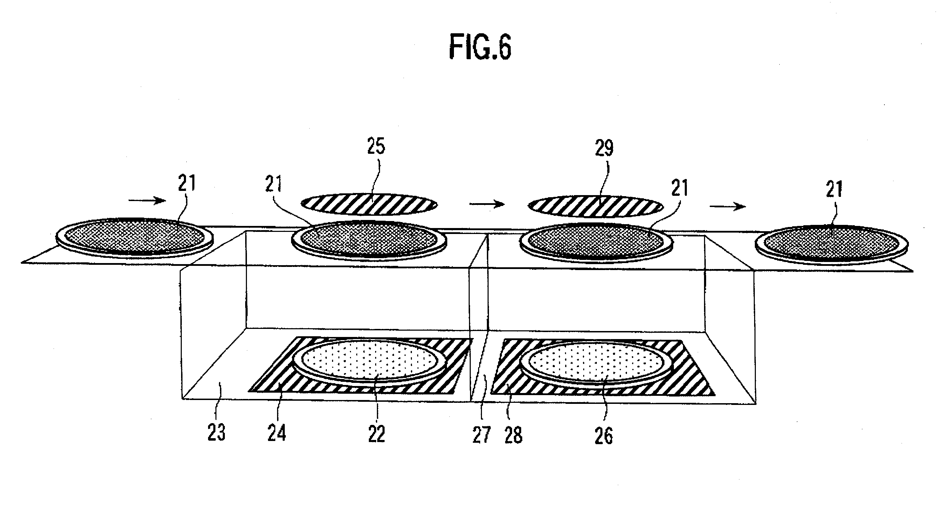

A method of producing a solar cell that utilizes the vapor deposition and heating method to form a p-n junction on a substrate will now be explained with reference to Figure 6.

One surface of a substrate 21 formed with metal electrodes is brought opposite an opening of a vapor deposition chamber 23 and a p-type organometal material 22 is heated and vaporized by a heater 24 to vapor-deposit p-type organometal material on the surface of the substrate 21 facing into the deposition chamber 23. At the same time, a heater 25 located above the substrate 21 is used to heat the substrate 21 from behind so as to simultaneously dry and react the vapor-deposited film and form a p-type oxide semiconductor thin film.

Next, the substrate 21 is moved to bring the p-type oxide semiconductor thin film opposite an opening of a vapor deposition chamber 27 and an n-type organometal material 26 is heated and vaporized by a heater 28 to vapor-deposit n-type organometal material on the p-type oxide semiconductor thin film on the substrate 21. At the same time, a heater 29 located above the substrate 21 is used to heat the substrate 21 from behind so as to simultaneously dry and react the vapor-deposited film and form an n-type oxide semiconductor thin film, thereby establishing a p-n junction structure that constitutes a solar cell.

The p-type organometal material, n-type organometal material, the heating and reaction conditions and the like are similar to those in the dip method.

Since, as explained in the foregoing, the vapor deposition and heating method effects vapor deposition, drying and reaction of the organic material of the oxide semiconductor simultaneously, it enables production of solar cells at a speed that compares favorably with that of the dip and coating methods.

Examples 1 and 2 set out below respectively describe a method of producing an n-type semiconductor thin film and a method of producing a p-type semiconductor thin film. It should be noted, however, that the present invention is in no way limited to these Examples.

### Example 1:

Zinc acetate 2-hydrate was used as an organometal containing an oxygen atom, aluminum nitrate 9-hydrate was used as n-type dopant, and ethanol was used as solvent. These were mixed by means of stirring at 80°C for three hours to obtain a transparent mixed solution.

A ceramic substrate was immersed in the mixed solution, immediately withdrawn and dried at 260°C for 10 minutes.

After an organometal molecule thin film had been formed on the substrate by the foregoing process, it was maintained at about 500°C for 1 hour to form an aluminum-containing zinc oxide thin film constituting an n-type semiconductor. Although aluminum was used as n-type dopant in this Example, it was ascertained that an increase in n-type carriers could also be realized by addition of boron, gallium, indium or the like.

### Example 2:

Copper acetate 1-hydrate was used as an organometal containing an oxygen atom, aluminum nitrate 9-hydrate was used as p-type dopant, and ethanol was used as solvent. These were mixed by means of stirring at 80°C for about three hours to obtain a transparent mixed solution.

A ceramic substrate was immersed in the mixed solution, immediately withdrawn and dried at 260°C for 10 minutes.

Once an organometal molecule thin film had been formed on the substrate in the foregoing manner, it was maintained at about 1,000°C for 1 hour to form an aluminum-containing copper oxide thin film constituting a p-type semiconductor.

Aluminum was added as a p-type dopant in this Example because it enables a broad light adsorption bandwidth to be achieved in a case where use as the absorption layer of a solar cell is intended when a zinc oxide system n-type layer is used. However, increase in p-type carriers can also be promoted by addition of gallium, strontium or the like.

In the present invention, an organic molecule having as structural elements both a semiconductor anion atom and cation atom is applied to a substrate by spraying, dipping, spin coating or the like and reacted under heating to obtain p-type and n-type semiconductor thin films whose p-n junctions enable rapid fabrication of large-area semiconductor devices, light-emitting elements and solar cells inexpensively and in high volume.

Moreover, since the substrate can be metal, ceramic, glass, heat-resistant plastic or any other material able to withstand the heating temperature for reaction, the invention enables solar cells to be directly fabricated on virtually any type of material, including roofs, walls, etc. of buildings and any of various types of equipment, such as motor vehicles and airplanes.

In addition, the production method according to the present invention is simple and inexpensive. As such, it enables a reduction in the amount of energy consumption required for the fabrication of semiconductor devices and solar cells.

The fact that the semiconductor provided by the invention is oxide semiconductor opens the way to production of a new generation of highly durable solar cells that are excellent in environmental friendliness and energy conservation.

As the method of producing semiconductor according to this invention can be applied for production of large-area light-emitting devices, it can be expected to help reduce electric power consumption for lighting by enabling inexpensive fabrication of large area light-emitting elements.

## Claims

1. A method of producing a metal oxide semiconductor thin film, **characterized in that** it comprises at least one step of adhering a mixed solution of an organometal containing an oxygen atom and a solvent to a substrate; and at least one step of decomposing and oxidizing the organometal by heat treatment at a predetermined temperature.

2. The method according to claim 1, **characterized in that** the semiconductor thin film is n-type, that the organometal is zinc acetate, zinc acetylacetonate, zinc formate, zinc hydroxide, zinc chloride, zinc nitrate, or one of their hydrates, and that the method further comprises a step of doping, before the step of adhering, the organometal with aluminum nitrate, aluminum acetate, aluminum chloride, aluminum sulfate, aluminum formate, gallium nitrate, gallium acetate, gallium chloride, gallium sulfate, gallium formate, indium nitrate, indium acetate, indium chloride, indium sulfate, indium formate, boron nitrate, boron acetate, boron chloride, boron sulfate, boron formate, or one of their hydrates.

3. The method according to claim 1, **characterized in that** the semiconductor thin film is p-type, that the organometal is copper acetate, copper formate, copper sulfate, copper chloride, copper nitrate, nickel acetate, nickel formate, nickel sulfate, nickel chloride, nickel nitrate, sodium cobalt nitrate, sodium cobalt acetate, sodium cobalt formate, sodium cobalt sulfate, sodium cobalt chloride, sodium nickel nitrate, or one of their hydrates, and that the method further comprises a step of doping, before the step of adhering, the organometal with aluminum nitrate, aluminum acetate, aluminum chloride, aluminum sulfate, aluminum formate, sodium nitrate, sodium acetate, sodium chloride, sodium sulfate, sodium formate, potassium nitrate, potassium acetate, potassium chloride, potassium sulfate, potassium formate, lithium nitrate, lithium acetate, lithium chloride, lithium sulfate, lithium formate, or one of their hydrates.

4. The method according to claim 1, **characterized in that** the at least one step of adhering comprises a first adhering step in which the organometal contains a p-type impurity and a second adhering step in which the organometal contains an n-type impurity, that the at least one step of decomposing and oxidizing comprises a first heat-treating step to form a p-type oxide semiconductor thin, film and a second heat-treating step to form an n-type oxide semiconductor thin film, and that the first adhering step, first heat-treating step, second adhering step and second heat-treating step are taken in the order mentioned, thereby fabricating a p-n junction.

5. The method according to claim 4, **characterized in that** the organometal containing the p-type impurity is copper acetate, copper formate, copper sulfate, copper chloride, copper nitrate, nickel acetate, nickel formate, nickel sulfate, nickel chloride, nickel nitrate, sodium cobalt nitrate, sodium cobalt acetate, sodium cobalt formate, sodium cobalt sulfate, sodium cobalt chloride, sodium nickel nitrate, or one of their hydrates and is doped with aluminum nitrate, aluminum acetate, aluminum chloride, aluminum sulfate, aluminum formate, sodium nitrate, sodium acetate, sodium chloride, sodium sulfate, sodium formate, potassium nitrate, potassium acetate, potassium chloride, potassium sulfate, potassium formate, lithium nitrate, lithium acetate, lithium chloride, lithium sulfate, lithium formate, or one of their hydrates, and that the organometal containing the n-type impurity is zinc acetate, zinc acetylacetonate, zinc formate, zinc hydroxide, zinc chloride, zinc nitrate, or one of their hydrates and is doped with aluminum nitrate, aluminum acetate, aluminum chloride, aluminum sulfate, aluminum formate, gallium nitrate, gallium acetate, gallium chloride, gallium sulfate, gallium formate, indium nitrate, indium acetate, indium chloride, indium sulfate, indium formate, boron nitrate, boron acetate, boron chloride, boron sulfate, boron formate, or one of their hydrates.

6. The method according to claim 1, **characterized in that** the metal oxide semiconductor thin film is produced utilizing a sol-gel process.

7. The method according to claim 1, **characterized in that** the substrate is made of metal, ceramic, glass or heat-resistant plastic.

8. , A metal oxide semiconductor thin film **characterized in that** it is fabricated by heat-treating a mixed solution of an organometal containing an oxygen atom and an organic solvent adhered to a substrate at a predetermined temperature to decompose and oxidize the organometal.

9. The semiconductor thin film according to claim 8, **characterized in that** the organometal is zinc acetate, zinc acetylacetonate, zinc formate, zinc hydroxide, zinc chloride, zinc nitrate, or one of their hydrates and is doped with aluminum nitrate, aluminum acetate, aluminum chloride, aluminum sulfate, aluminum formate, gallium nitrate, gallium acetate, gallium chloride, gallium sulfate, gallium formate, indium nitrate, indium acetate, indium chloride, indium sulfate, indium formate, boron nitrate, boron acetate, boron chloride, boron sulfate, boron formate, or one of their hydrates.

10. The semiconductor thin film according to claim 8, **characterized in that** the organometal is copper acetate, copper formate, copper sulfate, copper chloride, copper nitrate, nickel acetate, nickel formate, nickel sulfate, nickel chloride, nickel nitrate, sodium cobalt nitrate, sodium cobalt acetate, sodium cobalt formate, sodium cobalt sulfate, sodium cobalt chloride, sodium nickel nitrate, or one of their hydrates and is doped with aluminum nitrate, aluminum acetate, aluminum chloride, aluminum sulfate, aluminum formate, sodium nitrate, sodium acetate, sodium chloride, sodium sulfate, sodium formate, potassium nitrate, potassium acetate, potassium chloride, potassium sulfate, potassium formate, lithium nitrate, lithium acetate, lithium chloride, lithium sulfate, lithium formate, or one of their hydrates.

11. The semiconductor thin film according to claim 8, **characterized in that** it has a p-n junction formed of a p-type oxide semiconductor thin film obtained by heat-processing a mixed solution of an organometal containing a p-type impurity and a solvent adhered to the substrate at a predetermined temperature and an n-type oxide semiconductor thin film formed by adhering a mixed solution of an organometal containing an n-type impurity and a solvent to the thin film and heat-treating the adhered mixed solution at a predetermined temperature.

12. The semiconductor thin film according to claim 11, **characterized in that** the organometal containing the p-type impurity is copper acetate, copper formate, copper sulfate, copper chloride, copper nitrate, nickel acetate, nickel formate, nickel sulfate, nickel chloride, nickel nitrate, sodium cobalt nitrate, sodium cobalt acetate, sodium cobalt formate, sodium cobalt sulfate, sodium cobalt chloride, sodium nickel nitrate, or one of their hydrates and is doped with aluminum nitrate, aluminum acetate, aluminum chloride, aluminum sulfate, aluminum formate, sodium nitrate, sodium acetate, sodium chloride, sodium sulfate, sodium formate, potassium nitrate, potassium acetate, potassium chloride, potassium sulfate, potassium formate, lithium nitrate, lithium acetate, lithium chloride, lithium sulfate, lithium formate, or one of their hydrates, and that the organometal containing the n-type impurity is zinc acetate, zinc acetylacetonate, zinc formate, zinc hydroxide, zinc chloride, zinc nitrate, or one of their hydrates and is doped with aluminum nitrate, aluminum acetate, aluminum chloride, aluminum sulfate, aluminum formate, gallium nitrate, gallium acetate, gallium chloride, gallium sulfate, gallium formate, indium nitrate, indium acetate, indium chloride, indium sulfate, indium formate, boron nitrate, boron acetate, boron chloride, boron sulfate, boron formate, or one of their hydrates.

13. The semiconductor thin film according to claim 8, **characterized in that** the substrate is made of metal, ceramic, glass or heat-resistant plastic.
